# EUROPÄISCHE PATENTSCHRIFT

(11) **EP 2 258 490 B1**
(45) Veröffentlichungstag und Bekanntmachung des Hinweises auf die Patenterteilung: **06.04.2016**
(21) Anmeldenummer: 10005830.4
(22) Anmeldetag: 05.06.2010
(51) Int. Cl.: B08B 1/04, A46B 13/06, A46B 13/00, E04G 23/00, F24J 2/46, H01L 31/04

(54) **Vorrichtung und Verfahren zum Reinigen von Flächen einer Konstruktion**
Device and Method for cleaning surfaces of a construction
Dispositif et procédé destiné au nettoyage de surfaces d'une structure

(30) Priorität: 05.06.2009 DE 202009008001 U
(43) Veröffentlichungstag der Anmeldung: 08.12.2010
(73) Patentinhaber: Schletter GmbH, 83527 Kirchdorf (DE)
(72) Erfinder: Berndl, Georg, 84494 Niederbergkirchen (DE)
(74) Vertreter: Thum, Bernhard

(56) Entgegenhaltungen:
- AT-B- 197 038
- DE-A1- 3 443 124
- DE-A1- 19 716 741
- DE-U1- 9 015 554
- "Motor, schnell laufender, (MAH 4/5/6,3 -10/12,5)", Danfoss Datenblatt , 1. April 2005 (2005-04-01), Seiten 1-4, XP002687150, Gefunden im Internet: URL:http://www.danfoss.com/NR/rdonlyres/E8 6CCF22-2098-4555-B187-DAC0F10BC28A/0/521B0 749_DKCFNPD030A803_MotorschnelllaufenderMA H_DE.pdf [gefunden am 2012-11-08]

## Beschreibung

Die Erfindung betrifft eine Vorrichtung zum Reinigen von Flächen einer Konstruktion sowie ein Verfahren unter Verwendung der Vorrichtung.

Aus DE 197 167 41 A1 ist eine Reinigungsvorrichtung zum Reinigen von Glaskonstruktionen bekannt, bei der eine Walzenbürste und zwei Tellerbürsten über Elektromotoren angetrieben werden, wobei die Tellerbürsten an zwei Armen befestigt sind, die elektrisch ein- und ausgefahren werden können. Des Weiteren werden die Kabeltrommel für die elektrische Energieversorgung und die Schlauchtrommel für die Wasserzufuhr ebenfalls elektrisch angetrieben. Zusätzlich ist eine Steuer- und Regeleinrichtung, die als Mikrocomputer oder PC ausgebildet ist, vorhanden. Auch eine pneumatische Vorrichtung ist vorhanden, die zum Andrücken an außenliegende Konstruktionsteile dient.

Aus AT 197 038 B ist ein Reinigungsgerät gemäß dem Oberbegriff des Anspruchs 1 zur Nassreinigung von Flächen bekannt. Bei diesem Reinigungsgerät ist als einziges Reinigungselement eine Tellerbürste vorgesehen ist, die von einem hydraulischen Antrieb über zwei Zahnräder angetrieben wird. Während des Betriebs ist das Reinigungsgerät an einem Griff festzuhalten, um eine selbsttätige Rotation des Gehäuses des Reinigungsgeräts zu verhindern.

Aufgabe der Erfindung ist es, den Stand der Technik zu verbessern und insbesondere eine Vorrichtung zum Reinigen zu schaffen, die einfach aufgebaut ist und die ohne elektrische Energie für den Antrieb auskommt und auch in explosionsgefährdeten Bereichen eingesetzt werden kann und die sich selbst stabilisieren kann.

Gegenstand der Erfindung ist eine Vorrichtung zum Reinigen von Flächen einer Konstruktion, die einen Rahmen mit zumindest zwei Reinigungselementen aufweist, die als Tellerbürsten ausgeführt sind und gegeneinander laufen sowie eine Vorrichtung, die mit einem der Reinigungselemente in Verbindung steht und Elemente aufweist, die einen hydraulischen Antrieb des Reinigungselements ermöglichen sowie eine Zuführvorrichtung für Flüssigkeit.

In den letzten Jahren wurden verstärkt Solarzellen, um thermische Energie oder elektrische Energie zu gewinnen, auf Hausdächern installiert. Diese Solarzellen verschmutzen mit der Zeit, insbesondere auf landwirtschaftlichen Betrieben, bei denen durch das Einbringen von Staub entwickelnden Schüttgütern wie Getreide, Saatgut, Dünger etc. eine Staubwolke entsteht, die sich auf die Solarzellen, die auf dem Dach montiert sind, legt und auch durch Regen nicht mehr abgewaschen werden kann, sodass das Bedürfnis besteht, diese Solarzellen zu reinigen. Ein weiteres Problem ist, dass diese Dächer in nördlichen Breiten so gut wie immer ein Gefälle aufweisen, da sie Giebeldächer sind und so nicht ohne weiteres begehbar sind, und so schlecht manuell zu reinigen sind.

Die erfindungsgemäße Reinigungsvorrichtung, die einen Rahmen mit mindestens zwei Reinigungselementen, aber auch mehreren Relnigungselementen, wie 3, 4, 5, 6, 7, 8, 9, 10, 11, 12, 13 etc. aufweist, wobei diese Reinigungselemente Tellerbürsten sind, wobei zwei Tellerbürsten bevorzugt sind, die nebeneinander montiert sind und gegeneinander laufen, also eine im Uhrzeigersinn und die andere gegen den Uhrzeigersinn läuft. Vorzugsweise am einfachsten lässt sich verwirklichen, dass die Tellerbürsten gegeneinander laufen, wenn die angetriebene Tellerbürste mit der anderen Tellerbürste mit einem Riemen in Form einer Acht kraftschlüssig verbunden wird, wobei sich der Riemen also kreuzt. Ein nicht erfindungsgemäßer Antrieb der Tellerbürsten in der Form, dass sie miteinander laufen, geschieht am einfachsten, indem die angetriebene Tellerbürste mit der anderen Tellerbürste mit einem Riemen in Form einer 0 kraftschlüssig verbunden wird, wobei sich der Riemen also nicht kreuzt. Vorzugsweise läuft der Riemen in einer Nut zur Führung des Riemens in der Umfangsfläche der jeweiligen Tellerbürste. Prinzipiell könnte der Riemen auch jeweils in einer separaten Riemenscheibe, der mit der jeweiligen Tellerbürste verbunden ist, laufen, z.B. können die Riemenscheiben in kraftschlüssiger Verbindung mit der Zentralachse der Tellerbürste vorzugsweise oben auf der jeweiligen Tellerbürste angebracht sein.

Ein Vorteil, dass die Tellerbürsten gegeneinander laufen, also eine im Uhrzeigersinn und die andere gegen den Uhrzeigersinn läuft, ist der, dass sich dann die Reinigungsvorrichtung selbst stabilisiert und vorzugsweise an sich keine Vorrichtung mehr benötigt, um beim Reinigen von Solarzellen stabilisiert zu werden, also eine Solarzellenreihe senkrecht reinigt, ohne nach einer Seite seitlich auszubrechen.

Die erfindungsgemäße Reinigungsvorrichtung weist eine Vorrichtung auf, die mit dem Reinigungselement in Verbindung steht und Elemente aufweist, die einen hydraulischen Antrieb des Reinigungselements ermöglichen sowie eine Zuführvorrichtung für Flüssigkeit. Eine derartige Vorrichtung, die mit dem Reinigungselement in Verbindung steht und einen hydraulischen Antrieb des Reinigungselements ermöglicht, sind vorzugsweise Abprallelemente, die wie Turbinenschaufeln vorzugsweise um zumindest ein Reinigungselement angeordnet sind und mit einer Flüssigkeit vorzugsweise unter Druck, vorzugsweise Alkohole, Alkoholwassergemische oder bevorzugt Wasser, beaufschlagt werden, sodass sich zumindest ein Reinigungselement in Drehung versetzt und vorzugsweise über einen Riemen ein weiteres Reinigungselement antreibt. Es können nach diesem Prinzip aber auch mehrere Reinigungselemente angetrieben werden. Der Riemenantrieb hat gegenüber einem Antrieb über ein Zahnrad auf einen Zahnradkranz den Vorteil, dass er auch einen Schlupf aufweist, wenn z.B. beim Anlauf ein hohes Drehmoment auftritt. Es handelt sich bei den Reinigungselementen um Tellerbürsten, bei denen zwei nebeneinander liegende Tellerbürsten sich gegeneinander drehen.

In einer bevorzugten Ausführungsform ist der hydraulische Antrieb ein Wassermotor. Bei Wasserhydraulikmotoren wird hydraulische Energie (Druck, Wasserstrom) in mechanische Energie (Drehmoment, Drehzahl) umgesetzt. Wasserhydraulikmotoren sind Schnellläufermotoren mit konstanter Verdrängung. Bei einem gegebenen Wasserstrom und einem gegebenen Druck bestimmt die Größe der Verdrängung (Motorgröße) die Drehzahl und das Drehmoment. Bei einer gegebenen Verdrängung (Motorgröße) werden die Drehzahl von dem zugeführten Wasserstrom und das Drehmoment vom Druck bestimmt. Die Motoren sind als Axialkolbenverdränger nach dem Schrägscheibenprinzip aufgebaut. Das Axialkolbenprinzip ergibt eine leichte und kompakte Baugröße im Verhältnis zur jeweiligen Leistung. Die Motoren sind so konstruiert, dass alle beweglichen Teile vom Wasser geschmiert werden. Der Motor ist zur Verwendung von gewöhnlichem Trinkwasser oder auch Alkoholen, Alkoholwassergemischen geeignet. Die Motoren können während kürzerer Zeiträume auch im Reversierbetrieb laufen, aber mit einem etwas niedrigeren Wirkungsgrad und Anlaufdrehmoment. Damit das Anlaufdrehmoment nicht zu hoch ist, kann vor dem Zulauf der Flüssigkeit in den Wassermotor noch ein Ventil angebracht sein, um den Wasserdruck des Zulaufs zu regeln.

Statt eines Wassermotors kann in einer besonders bevorzugten Ausführungsform auch zumindest ein einzelnes Schaufelrad verwendet werden, das Abprallelemente, wie vorzugsweise Turbinenschaufeln, aufweist, die mit einer Flüssigkeit, wie bevorzugt Wasser, unter vorzugsweise hohem Druck beaufschlagt werden können und so in Rotation versetzt werden und dann über vorzugsweise ein Zahnrad oder eine Antriebsriemenscheibe, weiter vorzugsweise über ein Getriebe, die oben erwähnten Reinigungselemente in die für die Reinigung nötige Umdrehungsgeschwindigkeit versetzen.

Ein derartiger Wassermotor oder derartiges Schaufelrad kann zumindest ein Reinigungselement über vorzugsweise einen Riemen oder bevorzugt über ein Zahnrad antreiben, wobei die vorzugsweise weiteren Reinigungselemente mit dem zumindest einen angetriebenen Reinigungselement in kraftschlüssiger Verbindung über vorzugsweise Zahnräder und/oder Zahnkränze oder bevorzugt Riemen stehen.

Erfindungsgemäß weist eine Tellerbürste einen Zahnkranz um ihren Umfang auf, der über vorzugsweise einen Wassermotor über ein Zahnrad angetrieben wird oder bevorzugt über ein Zahnrad mit Abprallelementen, wie vorzugsweise Turbinenschaufeln. Dieser Zahnkranz der angetriebenen Tellerbürste kann nun entweder mit einer oder weiteren Tellerbürsten, die ebenfalls einen Zahnkranz um ihren Umfang aufweisen, in kraftschlüssiger Verbindung stehen und so werden weitere Tellerbürsten angetrieben oderes sind zu der direkt über ein Zahnrad über ihren Zahnkranz angetriebenen Tellerbürste weitere Reinigungselemente vorgesehen, indem eine oder mehrere weitere Tellerbürsten über einen Riemenantrieb angetrieben werden, der bevorzugt in Form einer Acht verlegt ist, damit die beiden Tellerbürsten gegeneinander laufen. Dieses Prinzip ist auch entsprechend auf Walzenbürsten anwendbar.

Vorzugsweise wird die Flüssigkeit, die zum hydraulischen Antrieb verwendet wird, auch zum Reinigen verwendet, indem die Flüssigkeit, nachdem sie für den hydraulischen Antrieb verwendet wird, an die Reinigungselemente geleitet wird. Die Flüssigkeit zum hydraulischen Antrieb kann auch nicht zum Reinigen, sondern nur zum Antrieb verwendet werden, indem die Flüssigkeit verworfen wird oder in einem Kreislauf kontinuierlich wiederverwendet wird, wobei vorzugsweise in einem derartigen Kreislauf vorzugsweise der Druck vorzugsweise durch eine Pumpe erhöht wird. Die Versorgung der Tellerbürsten mit Reinigungsflüssigkeit erfolgt vorzugsweise, indem die Tellerbürsten vorzugsweise Bohrungen über ihren Durchmesser aufweisen, durch die über darüber liegende Leitungen Flüssigkeit auf die Oberfläche der Tellerbürste gebracht wird. Bevorzugt ist auch die Zufuhr der Flüssigkeit über eine Leitung, die durch die Zentralachse der jeweiligen Tellerbürste geht, sodass die Flüssigkeit direkt an die Borsten der Tellerbürste gebracht wird.

In einer weiteren bevorzugten Ausführungsform weist die erfindungsgemäße Vorrichtung zum Reinigen eine Führungsvorrichtung auf, die die Vorrichtung zum Reinigen in einer Längsöffnung der zu reinigenden Oberfläche führt. Die Führungsvorrichtung wird vorzugsweise zwischen zwei Reinigungselementen, wie zwei Tellerbürsten angebracht. Diese Führungsvorrichtung gleitet in einer Öffnung, wie einem Spalt, wie er z.B. zwischen Solarzellen, insbesondere photovoltaischen oder thermischen Solarzellen, meist vorhanden ist. Bevorzugt ist diese Führungsvorrichtung derart aufgebaut, dass in einer Schiene zwei Räder hintereinander montiert sind (ähnlich einem Tretroller), wobei sich diese Räder vorzugsweise zu ihrer Lauffläche hin verjüngen und umso besser in den Spalten, die z.B. zwischen zwei Reihen von Solarzellen bestehen, die Reinigungsvorrichtung führen können. Möglich wäre auch eine kufenförmige Führungsvorrichtung. Möglich ist auch jeweils eine Führungsvorrichtung an beiden Seiten des Rahmens der Reinigungsvorrichtung, die jeweils in einem Spalt gleiten, z.B. in dem Spalt, der zwischen zwei Solarzellenreihen vorhanden ist. So gleitet die Führungsvorrichtung jeweils in dem Spalt auf den beiden Seiten einer Solarzellenreihe, die gereinigt wird. Bei gegeneinander laufenden Tellerbürsten ist diese Vorrichtung vorzugsweise nicht notwendig.

Die erfindungsgemäße Reinigungsvorrichtung kann zum Reinigen aller Flächen von Konstruktionen, wie Dächern, Fahrzeugen, wie Landfahrzeuge, See- und Luftfahrzeuge, Schiffs- und Flugzeugaufbauten, verwendet werden. Vorzugsweise handelt es sich bei der erfindungsgemäßen Reinigungsvorrichtung um eine Solarzellenreinigungsvorrichtung, bevorzugt eine Photovoltaiksolarzellenreinigungsvorrichtung oder Thermosolarzellenreinigungsvorrichtung, wobei die Photovoltaiksolarzellenreinigungsvorrichtung besonders bevorzugt ist.

Die erfindungsgemäße Reinigungsvorrichtung wird vorzugsweise derart eingesetzt, dass, wenn z.B. photovoltaische Solarzellen zu reinigen sind, die Reinigungsvorrichtung an Seilen oder bevorzugt am Zuführschlauch für die Flüssigkeit zwischen einer Zellenreihe, z.B. vom oberen Teil eines Schrägdachs, wie eines Pultdachs oder Satteldachs, vorzugsweise mit der Führungsvorrichtung in dem Spalt zwischen zwei Solarzellenreihen abgelassen und dann wieder hochgezogen wird, wobei die Reinigungsvorrichtung sowohl beim Ablassen als auch beim Hochholen in Betrieb sein kann. Sobald die Reinigungsvorrichtung wieder auf der Spitze des Dachs ist, kann sie um eine Zellenreihe weiter versetzt werden. Bei plan in der Horizontalen verlegten Solarzellen müsste die Reinigungsvorrichtung vorzugsweise von zwei sich gegenüberliegenden Stellen hin und her gezogen werden.

Vorteil der erfindungsgemäßen Reinigungsvorrichtung ist, dass sie ohne elektrischen Strom auskommt und somit einfach nur mit Flüssigkeit, wie vorzugsweise Wasser, betrieben werden kann, die sowohl den Antrieb als auch die Reinigung gewährleistet, was den Einsatz der erfindungsgemäßen Reinigungsvorrichtung einfach und effizient macht. Zusätzlich kann die erfindungsgemäße Reinigungsvorrichtung auch in explosionsgefährdeten Bereichen, wie bei Tankschiffen und Flugzeugen verwendet werden.

### Figur 1

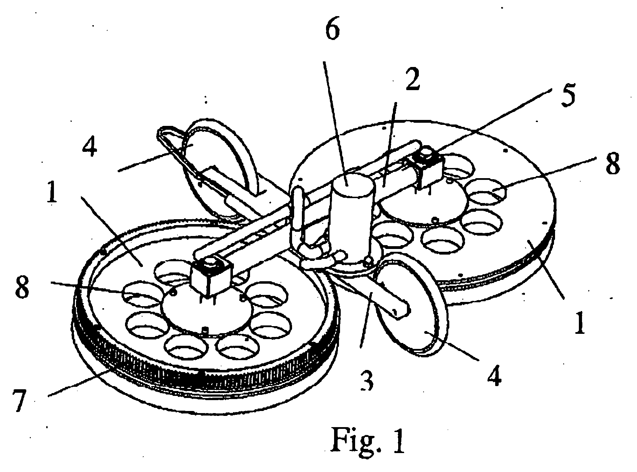

In Figur 1 wird die erfindungsgemäße Reinigungsvorrichtung in perspektivischer Draufsicht gezeigt. Über einen Rahmen 2 in Form eines Trageelements 5 sind zwei Tellerbürsten 1 verbunden, dazwischen befindet sich eine Führungsvorrichtung 3 mit zwei hintereinander laufenden Rädern 4, wobei auf der Schiene der Führungsvorrichtung 3 ein Wassermotor 6 angebracht ist, der in kraftschlüssiger Verbindung mit dem Zahnkranz 7 ist, der um den Umfang einer Tellerbürsten 1 läuft. Die Tellerbürste 1 ohne Zahnkranz wird über einen Riemen (nicht sichtbar) angetrieben, der in kraftschlüssiger Verbindung mit der direkt angetriebenen Tellerbürste 1 mit Zahnkranz 7 steht. Beide Tellerbürsten 1 weisen Bohrungen 8 auf, über die Reinigungsflüssigkeit, wie Wasser oder Wasseralkoholgemische, eingebracht werden können.

## Patentansprüche

1. Vorrichtung zum Reinigen von Flächen einer Konstruktion, aufweisend
- einen Rahmen (2) mit einer ersten Tellerbürste (1),
- einer Zuführeinrichtung für Flüssigkeit, und
- einem als Wassermotor (6) oder Schaufelrad ausgeführten hydraulischen Antrieb, der die erste Tellerbürste (1) über ein Zahnrad antreibt,
**dadurch gekennzeichnet, dass**
- die erste Tellerbürste (1) um ihren Umfang einen Zahnkranz (7) aufweist, der über das Zahnrad angetrieben ist,
- mindestens eine weitere Tellerbürste (1) vorgesehen ist, wobei die erste Tellerbürste (1) und die weitere Tellerbürste (1) gegeneinander laufen, und
- entweder die weitere Tellerbürste (1) ebenfalls einen Zahnkranz um ihren Umfang aufweist und die erste Tellerbürste (1) und die weitere Tellerbürste (1) über Zahnräder und/oder die Zahnkränze in kraftschlüssiger Verbindung stehen,
- oder die weitere Tellerbürste (1) mit der ersten Tellerbürste (1) über einen Riemen in kraftschlüssiger Verbindung steht, der in Form einer Acht verlegt ist.

2. Vorrichtung zum Reinigen nach Anspruch 1, **dadurch gekennzeichnet, dass** die Flüssigkeit, die für den hydraulischen Antrieb verwendet wird, auch gleichzeitig als Flüssigkeit zum Reinigen dient.

3. Vorrichtung zum Reinigen nach einem der vorhergehenden Ansprüche, **dadurch gekennzeichnet, dass** die Vorrichtung zum Reinigen eine Führungsvorrichtung (3) aufweist, die die Vorrichtung zum Reinigen in einer Öffnung der zu reinigenden Oberfläche führt.

4. Vorrichtung zum Reinigen nach Anspruch 3, **dadurch gekennzeichnet, dass** die Führungsvorrichtung (3) zwei hintereinander laufende Räder (4) aufweist, die in der Öffnung in Form eines Spalts der zu reinigenden Oberfläche laufen.

5. Vorrichtung zum Reinigen nach einem der Ansprüche 1 bis 4, **dadurch gekennzeichnet, dass** der hydraulische Antrieb ein Wassermotor (6) ist, der als Axialkolbenverdränger nach dem Schrägscheibenprinzip aufgebaut ist.

6. Vorrichtung zum Reinigen nach Anspruch 2, **dadurch gekennzeichnet, dass** eine Versorgung der Tellerbürsten (1) mit der Flüssigkeit erfolgt, indem in den Tellerbürsten (1) über ihren Durchmesser jeweils Bohrungen (8) vorgesehen sind, durch die über darüber liegende Leitungen die Flüssigkeit auf die Oberfläche der Tellerbürsten (1) gebracht wird.

7. Vorrichtung zum Reinigen nach Anspruch 2, **dadurch gekennzeichnet, dass** eine Versorgung der Tellerbürsten (1) mit der Flüssigkeit erfolgt, indem die Zufuhr der Flüssigkeit über Leitungen erfolgt, die durch Zentralachsen der Tellerbürsten (1) verlaufen.

8. Vorrichtung zum Reinigen nach Anspruch 2, **dadurch gekennzeichnet, dass** die Flüssigkeit nach Verwendung durch den hydraulischen Antrieb an die Tellerbürsten (1) geleitet wird.

9. Verfahren zum Reinigen von Solarzellen auf einem Schrägdach unter Verwendung einer Vorrichtung zum Reinigen nach einem der Ansprüche 1 bis 8, wobei die Vorrichtung zum Reinigen von einem oberen Teil des Schrägdachs an Seilen oder einem Zuführschlauch abgelassen und dann wieder hochgezogen wird.

## Claims

1. Device for cleaning of surfaces of a construction, comprising
- a frame (2) having a first disc brush (1),
- a feeding unit for liquid, and
- a hydraulic drive implemented as water engine (6) or paddle wheel, which drives the first disc brush (1) via a gear wheel,
**characterized in that**
- the first disc brush (1) comprises a sprocket (7) around its circumference, which is driven by the gear wheel,
- at least a further disc brush (1) is provided, wherein the first disc brush (1) and the further disc brush (1) run against each other, and
- either the further disc brush (1) also comprises a sprocket around its circumference and the first disc brush (1) and the further disc brush (1) are in force-fitting connection via gear wheels and/or the sprockets,
- or the further disc brush (1) is in force-fitting connection with the first disc brush (1) via a belt which is set in form of an eight.

2. Device for cleaning according to claim 1, **characterized in that** the liquid which is used for the hydraulic drive (6) also serves as cleaning liquid at the same time.

3. Device for cleaning according to one of the preceding claims, **characterized in that** the device for cleaning comprises a guiding device (3), which guides the device for cleaning in an opening of the surface to be cleaned.

4. Device for cleaning according to claim 3, **characterized in that** the guiding device (3) comprises two wheels (4) running one behind the other which run in the opening in form of a slot of the surface to be cleaned.

5. Device for cleaning according to one of the claims 1 to 4, **characterized in that** the hydraulic drive is a water engine (6), which is configured as an axial piston displacement device according to the swash plate principle.

6. Device for cleaning according to claim 2, **characterized in that** a supply of the disc brush (1) with the liquid is effected by holes (8) provided in the respective disc brushes (1) over their diameter, wherein through the holes said liquid is applied to the surface of the disc brushes (1) via lines arranged above.

7. Device for cleaning according to claim 2, **characterized in that** a supply of the disc brushes (1) with said liquid is effected such that the supply of said liquid is effected via lines passing through the central axes of the disc brushes (1).

8. Device for cleaning according to claim 2, **characterized in that** said liquid after being used by the hydraulic drive is passed to the disc brushes (1).

9. Method for the cleaning of solar cells on a slanting roof by use of a device for cleaning according to one of the claims 1 to 8, whereas the device for cleaning of an upper part of the slanted roof is let off and then lifted up again by ropes or a feeding tube.

## Revendications

1. Dispositif de nettoyage de surfaces d'une construction, présentant
- un cadre (2) avec une première brosse circulaire (1),
- un dispositif d'amenée de liquide, et
- un entraînement hydraulique réalisé sous la forme d'un moteur hydraulique (6) ou d'une roue à aubes qui entraîne la première brosse circulaire (1) par une roue dentée,
**caractérisé en ce que**
- la première brosse circulaire (1) présente à sa périphérie une couronne dentée (7) qui est entraînée par la roue dentée,
- au moins une autre brosse circulaire (1) est prévue, la première brosse circulaire (1) et l'autre brosse circulaire (1) tournant en sens contraires, et
- soit l'autre brosse circulaire (1) présente également une couronne dentée à sa périphérie et la première brosse circulaire (1) et l'autre brosse circulaire (1) sont solidarisées par l'intermédiaire de roues dentées et/ou des couronnes dentées,
- soit l'autre brosse circulaire (1) est en liaison par conjugaison de forces avec la première brosse circulaire (1) par l'intermédiaire d'une courroie qui est posée en forme de huit.

2. Dispositif de nettoyage selon la revendication 1, **caractérisé en ce que** le liquide qui est utilisé pour l'entraînement hydraulique sert en même temps de liquide de nettoyage.

3. Dispositif de nettoyage selon l'une des revendications précédentes, **caractérisé en ce que** le dispositif de nettoyage présente un dispositif de guidage (3) qui guide le dispositif de nettoyage dans une ouverture de la surface à nettoyer.

4. Dispositif de nettoyage selon la revendication 3, **caractérisé en ce que** le dispositif de guidage (3) présente deux roues (4) tournant l'une derrière l'autre qui roulent dans l'ouverture en forme de fente de la surface à nettoyer.

5. Dispositif de nettoyage selon l'une des revendications 1 à 4, **caractérisé en ce que** l'entraînement hydraulique est un moteur hydraulique (6) qui est conçu comme une pompe à pistons axiaux selon le principe du plateau incliné.

6. Dispositif de nettoyage selon la revendication 2, **caractérisé en ce qu'**une alimentation des brosses circulaires (1) en liquide est réalisée par le fait que des trous (8) sont prévus dans chacune des brosses circulaires (1) sur leur diamètre, à travers lesquels le liquide est amené à la surface des brosses circulaires (1) par des conduites situées au-dessus.

7. Dispositif de nettoyage selon la revendication 2, **caractérisé en ce qu'**une alimentation des brosses circulaires (1) en liquide est réalisée par le fait que le liquide est amené par des conduites qui passent à travers les axes centraux des brosses circulaires (1).

8. Dispositif de nettoyage selon la revendication 2, **caractérisé en ce que** le liquide est dirigé vers les brosses circulaires (1) après avoir été utilisé par l'entraînement hydraulique.

9. Procédé de nettoyage de cellules solaires sur un toit en pente en utilisant un dispositif de nettoyage selon l'une des revendications 1 à 8, dans lequel on fait descendre le dispositif de nettoyage depuis une partie supérieure du toit en pente le long de câbles ou d'un tuyau d'amenée, puis on le remonte.
